# DEMANDE DE BREVET EUROPEEN

(11) **EP 1 811 064 A1**
(43) Date de publication de la demande: **25.07.2007**
(21) Numéro de dépôt: 06447007.3
(22) Date de dépôt: 12.01.2006
(51) Int. Cl.: C30B 11/00, C30B 15/10

(54) **Creuset pour le traitement de silicium à l'état fondu**

(71) Demandeur: VESUVIUS CRUCIBLE COMPANY, Wilmington, DE 19803 (US)
(72) Inventeur: Rancoule, Gilbert, 59700 Marcq-en-Baroeul (FR)
(74) Mandataire: Debled, Thierry

(57) **Abrégé**

L'invention se rapporte à un creuset pour le traitement de silicium à l'état fondu comprenant un corps de base avec une surface de fond et des parois latérales définissant un volume intérieur. Selon l'invention, le corps de base comprend au moins 65% en poids de carbure de silicium et de 12 à 30% en poids d'au moins un constituant choisi parmi l'oxyde ou le nitrure de silicium. En outre, le corps de base comprend un revêtement d'oxyde et/ou de nitrure de silicium, au moins sur les surfaces définissant le volume intérieur du creuset.

Un tel creuset peut être réutilisé un certain nombre de fois sans voir son intégrité physique se dégrader significativement contrairement aux creusets de l'état de la technique.

## Description

La présente invention se rapporte à un creuset pour le traitement du silicium à l'état fondu, à la fabrication d'un tel creuset et à l'utilisation de ce creuset pour traiter du silicium à l'état fondu.

De nos jours, la demande de silicium de pureté très élevée a augmenté de manière très significative. Les applications du silicium de haute pureté dans la génération d'énergie photovoltaique sont largement répandues. Les crises énergétiques successives ont encore renforcé ce besoin.

La présente demande a pour objet un récipient utilisé pour le traitement du silicium à l'état fondu. Le traitement en question peut consister en la cristallisation du silicium soit par solidification directionnelle, soit par étirage d'un cristal à partir d'un bain de silicium fondu. Le traitement en question peut également consister en un traitement métallurgique destiné à produire du silicium de très haute pureté ou un de ses alliages. Il peut donc s'agir d'un traitement métallurgique d'alliages ou de minerais visant à en éliminer certaines impuretés.

Pour ce genre d'applications, il est bien connu d'utiliser des creuset en quartz ou à base d'autres matériaux essentiellement constitués de dioxyde de silicium. En effet, dès lors que le constituant principal du creuset est le silicium sous forme d'un de ses oxydes, le risque de contamination du contenu du creuset par d'autres espèces chimiques est fortement réduit. Les creusets en quartz présentent toutefois l'inconvénient majeur d'être attaqué par le silicium à l'état fondu, ce qui a pour conséquence que le lingot de silicium en cours de solidification tend à adhérer aux parois du creuset en quartz. Dès lors que le quartz et le silicium ont des coefficients de dilatation différents, des contraintes mécaniques très importantes peuvent être induites soit dans le lingot résultant en des défauts de cristallisation, soit dans les parois du creuset provoquant sa fissuration. En outre, le lingot de silicium une fois solidifié adhère fortement aux parois du récipient en quartz et il est pratiquement impossible de pouvoir en extraire le lingot sans détruire le creuset ou tout au moins sans l'endommager sérieusement.

Le quartz et certains dérivés de silice sont également connus pour subir des changements de phases cristallographiques durant leur cycle thermique. Ces changements de phase cristallographique induisent des contraintes mécaniques très importantes au sein de la paroi du creuset En outre, ils peuvent également induire des changements de densité et donc de conductivité thermique au sein de la paroi, conduisant à des problèmes de perte d'homogénéité de la transmission ou du retrait d'énergie vers ou depuis le silicium. A ce jour, ce problème crucial n'a pas encore trouvé de solution susceptible d'être mise en oeuvre par l'industrie.

En outre, aux températures d'utilisation, le quartz a tendance à se déformer et à changer de géométrie. Ces changements de géométrie sont relativement difficile à gérer car le four de traitement dans lequel se trouve le récipient contenant du silicium à l'état fondu doit chauffer d'une manière totalement contrôlée la quantité de silicium en cours de traitement Toute déformation de la paroi du récipient entraîne une perte d'homogénéité de la transmission ou du retrait d'énergie vers ou depuis le silicium qui s'ajoute à la perte de géométrie du lingot de silicium pendant la cristallisation.

On a pu partiellement remédier à ce problème en renforçant les parois extérieures du creuset en quartz au moyen de plaques de carbone, plus particulièrement en graphite.

Des telles plaques en carbone, et plus particulièrement en graphite, sont très largement utilisées dans toutes sortes de procédés mis en oeuvre à haute température du fait de leur excellente résistance aux contraintes d'ordre thermique sur de relativement longues périodes. Des creusets en graphite par exemple ont pu être utilisés pour recevoir un bain de germanium lors de la mise en oeuvre d'un procédé de traction de cristal selon la méthode de Czochralski. Jusqu'à présent, il n'a toutefois pas été possible d'utiliser de tels creusets en graphite pour le traitement du silicium dès lors qu'à haute température, le bain de silicium en fusion attaque les parois de graphite et forme du carbure de silicium dont la présence est incompatible avec les exigences de pureté requise. Selon la technique utilisée actuellement, comme on l'a indiqué ci-avant, on met donc en oeuvre les différents procédés de traitement du silicium à haute température dans un récipient en quartz ou autre matériau à base de silice dont les parois ont été renforcées au moyen de plaques de carbone, plus particulièrement en graphite.

Cette technique non plus n'est pas exempte de problème. Il est en effet bien connu que les phases gazeuses, dans l'environnement du bain de silicium liquide, influencent la formation d'un équilibre entre la vapeur de silicium qui s'échappe du bain de silicium à l'état fondu et l'atmosphère de monoxyde de carbone régnant dans le four. Des réactions sont observées aussi bien sur le carbone ou graphite que dans le bain de silicium, conduisant à un changement de propriétés physique et chimique

Partant du même concept consistant à éviter d'introduire d'autres constituants que le silicium, on a également déjà proposé dans l'état de la technique d'utiliser des creusets constitués de nitrure de silicium. Ainsi, le document WO-A1-2004/016835 décrit un creuset essentiellement constitué de nitrure de silicium. Même si certaines des propriétés de ce creuset sont satisfaisantes, son prix rend son utilisation irréaliste à l'heure actuelle. En outre, il a aussi été rapporté que ces creusets sont également sensibles à la déformation à haute température.

La demanderesse s'est donc fixé comme objectif de fournir un récipient pour le traitement du silicium à l'état fondu qui ne présenterait pas les inconvénients rencontrés dans l'état de la technique. En particulier, il serait souhaitable que le creuset fourni puisse être réutilisé un certain nombre de fois sans voir son intégrité physique se dégrader significativement. En outre, il faudrait que les propriétés de conductivité thermique du creuset en question ne soient pas modifiées en cours d'utilisation; en d'autres termes, que le matériau ne soit pas sensible ni à la déformation, ni à un changement de phase cristallographique. Enfin, il est impératif que le creuset ne soit pas la cause d'une quelconque pollution du silicium.

La demanderesse a établi que ces objectifs et d'autres étaient atteints avec un creuset selon la revendication 1. Un tel creuset comprend donc un corps de base avec une surface de fond et des parois latérales définissant un volume intérieur constitué principalement (au moins 65 % en poids du matériau) de carbure de silicium. Il est tout à fait surprenant que l'on puisse réaliser un creuset pour le traitement du silicium à l'état fondu en un matériau constitué principalement de carbure de silicium. En effet, jusqu'à présent, on a toujours tenté d'éviter la présence de carbure de silicium qui est perçue comme un problème dans tout procédé de traitement du silicium à l'état fondu.

Au contraire, la demanderesse a montré qu'un creuset comprenant un corps de base constitué principalement de carbure de silicium ne présentait pas les inconvénients rencontrés avec les creusets conventionnels. En particulier, le fait que le composant principal du corps de base consiste en du carbure de silicium qui présente une phase cristallographique bien définie et qui ne subit pas de changement de phase aux températures de traitement du silicium à l'état fondu, permet de supprimer tous les problèmes de perte d'homogénéité du transfert/retrait d'énergie rencontrés avec les creusets conventionnels. En outre, le carbure de silicium ne présente pas de phase plastique à ces températures et ne se déforme donc pas.

Grâce à ces excellents propriétés, un tel creuset peut être réutilisé un nombre significatif de fois alors que les creusets conventionnels doivent être remplacés après chaque utilisation. Il est tout à fait surprenant que la solution à ce problème provienne justement de l'utilisation d'un matériau considéré jusqu'alors comme source de problèmes.

Le matériau formant le corps de base du creuset comprend en outre de 12 à 30% en poids d'un ou plusieurs constituants choisis parmi l'oxyde ou le nitrure de silicium. Le reste du matériau formant le corps de base du creuset peut comprendre jusqu'à 13% en poids d'un ou plusieurs autres constituants comme des liants (chimiques, hydraulique ou autre), des agents régulateurs de fluidité de la composition avant mise en oeuvre et cuisson, etc.

Le constituant choisi parmi l'oxyde ou le nitrure de silicium peut être introduit en tant que tel dans la composition mise en oeuvre pour former le corps de base ou encore être introduite sous la forme de silicium métallique qui sera soit oxydé ou nitruré pendant la cuisson du creuset Les conditions de cuisson (atmosphère oxydante ou nitrurante) seront donc choisie en fonction de la composition désirée. On notera que l'oxyde de silicium peut également avoir un effet sur la fluidité de la composition avant mise en oeuvre et cuisson ainsi d'ailleurs qu'un effet liant, en particulier lorsque ce composé est introduit sous forme de silice fumée. Dans ces cas, on en tient compte bien évidemment une seule fois (dans les 12 à 30% en poids d'un ou plusieurs constituants choisis parmi l'oxyde et/ou le nitrure de silicium).

D'autres agents régulateurs de viscosité peuvent également être introduits afin de modifier les propriétés à chaud du creuset L'ajout de fines particules d'alumine réactive (granulométrie inférieure ou égale à 200 µm) est particulièrement avantageux pour son effet de modificateur de fluidité à la mise en oeuvre ainsi que son effet liant après cuisson.

D'autres liants pouvant convenir comprennent par exemple les résines organiques (laissant un résidu carboné après cuisson), la magnésie et l'aluminate et/ou le silicate de calcium. Selon un mode de réalisation avantageux, la liaison est réalisée par formation in situ d'un lien de type nitrure ou oxyde de silicium. Une telle liaison est facilement obtenue en régulant le conditions de cuisson de la pièce et en particulier de l'atmosphère de cuisson de la pièce.

En outre, il a été établi qu'il est nécessaire de munir les parois internes du creuset d'un revêtement de type nitrure de silicium tels que décrits par exemple dans WO-A1-2004053207 ou dans la demande de brevet européen 05447224. de type oxyde de silicium ou d'une combinaison des deux types précités comme décrit par exemple dans la demande de brevet européen 05076520 ou le document WO-A1-2005/106084. En général, on utilise un revêtement de type oxyde pour la cristallisation de silicium en monocristal et de type nitrure pour la cristallisation polycristalline du silicium. On notera que le revêtement peut être produit lors de la cuisson d'un creuset cru comprenant du silicium (par exemple une cuisson en atmosphère nitrurante produira un revêtement de surface de type nitrure de silicium alors qu'une cuisson en atmosphère oxydante produira un revêtement de surface de type oxyde de silicium).

Selon l'invention, le corps de base est lié. Comme on l'a indiqué ci-dessus, il peut s'agir d'un liant hydraulique (par exemple silicate ou aluminate de calcium) formant ainsi une composition de type ciment, d'un liant chimique (par exemple le silicate de magnésium) ou d'un liant type "sans ciment" (par exemple les gels, les orthosilicates, etc.) ou encore d'un lien produit par liaison réactive (lien carbone, cuisson nitrurante, etc.).

Avantageusement, le carbure de silicium sera mis en oeuvre selon une formule de distribution granulométrique bien définie. En particulier, il est préférable que la fraction de grains les plus grossiers soit constituée du carbure de silicium en sorte de réaliser une matrice de carbure de silicium constituée de gros grains dans laquelle des grains plus fins de nitrure et ou d'oxyde de silicium seront présents. La majorité du carbure de silicium sera donc constituée de préférence de grains supérieurs à 200 µm alors que le nitrure de silicium, l'oxyde de silicium et/ou le silicium métallique seront introduits de préférence sous formes de grains inférieurs à 10 µm.

Les exemples qui suivent illustrent plusieurs mode de réalisation de l'invention. Dans la Table 1 qui suit, on fournit différents exemples de matériaux selon l'invention constituant le corps de base de creusets pour le traitement de silicium à l'état fondu. Dans cette table, la première colonne indique la nature des constituants, les colonnes 2 à 13 indiquent les pourcentages en poids de ces différents constituants. Les exemples A1, A2, C1, C2, E1 et E2 illustrent plusieurs variantes de lien hydraulique. Les exemples A à F illustrent différentes variantes de liaison chimique ou réactive.

Des creusets ont été préparés à partir de ces matériaux et leurs parois internes ont été enduites d'un revêtement de type nitrure ou oxyde de silicium. On a ensuite procédé dans chacun de ces creusets à la cristallisation d'une quantité identique de silicium. On a ainsi pu observer qu'aucun de ces creusets n'était endommagé au terme de la cristallisation du silicium en sorte qu'ils pouvaient être immédiatement engagés dans un processus ultérieur de cristallisation sans nécessiter de réparation.

**TABLE 1**

| | | A1 | A2 | A | B | C1 | C2 | C | D | E1 | E2 | E | F |
|---|---|---|---|---|---|---|---|---|---|---|---|---|---|
| Carbure de silicium | 1-3 mm | 25 | 25 | 25 | 25 | 20 | 20 | 20 | 20 | 25 | 25 | 25 | 22 |
| | 0.2-1 mm | 20 | 20 | 20 | 20 | 30 | 30 | 30 | 25 | 25 | 25 | 25 | 25 |
| | <.025 mm | 30 | 30 | 30 | 30 | 30 | 30 | 30 | 30 | 20 | 20 | 20 | 20 |
| Total carbure de silicium | | 75 | 75 | 75 | 75 | 80 | 80 | 80 | 75 | 70 | 70 | 70 | 67 |
| Nitrure de silicium | | 17 | 15 | 17 | 10 | 15 | 8 | 18 | | 25 | 10 | 25 | 17 |
| Oxyde de silicium | | 5 | 8 | 5 | 5 | | 4 | | 12 | | 6 | | 10 |
| Total nitrure et oxyde | | 22 | 23 | 22 | 15 | 15 | 12 | 18 | 12 | 25 | 16 | 25 | 27 |
| Alumine | | 1 | | 2 | 8 | | 3 | | 9 | 2 | 11 | 3 | 2 |
| Aluminate de calcium | | 2 | 2 | | | 5 | 5 | | | 3 | 3 | | |
| Oxyde de magnésium | | | | 1 | | | | 2 | | | | 2 | 1 |
| Carbone | | | | | 2 | | | | 4 | | | | 3 |
| Total autres | | 3 | 2 | 3 | 10 | 5 | 8 | 2 | 13 | 5 | 14 | 5 | 6 |
| Total | | 100 | 100 | 100 | 100 | 100 | 100 | 100 | 100 | 100 | 100 | 100 | 100 |

## Revendications

1. Creuset pour le traitement de silicium à l'état fondu comprenant un corps de base avec une surface de fond et des parois latérales définissant un volume intérieur, le corps de base comprenant
- au moins 65% en poids de carbure de silicium;
- de 12 à 30% en poids d'au moins un constituant choisi parmi l'oxyde ou le nitrure de silicium;
le corps de base comprenant en outre au moins un revêtement d'oxyde et/ou de nitrure de silicium, au moins sur les surfaces définissant le volume intérieur du creuset.

2. Creuset selon la revendication 1, **caractérisé en ce que** le corps de base comprend en outre jusqu'à 13% en poids d'un (ou plusieurs) autre(s) constituant(s) choisi(s) parmi le carbone, l'oxyde de magnésium, l'oxyde d'aluminium, le silicate et ou l'aluminate de calcium.

3. Creuset selon la revendication 1 ou 2, **caractérisé en ce qu'**une couche d'oxyde de silicium est présente entre le revêtement de surface et la paroi des surfaces définissant le volume intérieur du creuset.

4. Creuset selon l'une quelconque des revendications 1 à 3, **caractérisé en ce qu'**une couche d'oxyde de silicium est présente à la surface des parois du corps de base, du côté opposé au côté définissant le volume interne.

5. Creuset selon l'une quelconque des revendications 1 à 4, **caractérisé en ce qu'**au moins 50% en poids des grains de carbure de silicium ont une taille de particule supérieure à 200 µm.

6. Creuset selon l'une quelconque des revendications 1 à 5, **caractérisé en ce que** les grains d'oxyde ou de nitrure de silicium ou les particules de silicium métallique ont une taille de particule inférieure à 10 µm.

7. Procédé pour la fabrication d'un creuset selon l'une quelconque des revendications précédentes, comprenant les étapes suivantes;
a) façonnage d'un corps de base avec une surface de fond et des parois latérales définissant un volume intérieur,
b) séchage du corps de base;
c) cuisson du corps de base; et
d) formation d'un revêtement d'oxyde et/ou de nitrure de silicium, au moins sur les surfaces définissant le volume intérieur du creuset.

8. Procédé selon la revendication 7, **caractérisé en ce que** les étapes c) et d) sont réalisées simultanément par cuisson du corps de base façonné et séché en atmosphère oxydante ou nitrurante.

9. Procédé selon la rev.7, **caractérisé en ce que** l'étape d) de formation du revêtement comprend l'application d'un revêtement avant l'étape de cuisson du corps de base.
